# EUROPEAN PATENT APPLICATION

(11) **EP 4 675 512 A1**
(43) Date of publication of application: **07.01.2026**
(21) Application number: 23925276.0
(22) Date of filing: 01.03.2023
(51) Int. Cl.: G06N 10/20, G06F 8/41

(54) **QUBIT ALLOCATION PROGRAM, QUBIT ALLOCATION METHOD, AND QUBIT ALLOCATION DEVICE**

(71) Applicant: FUJITSU LIMITED, Kawasaki-shi, Kanagawa 211-8588 (JP)
(72) Inventor: YAMAGUCHI, Masaomi, Kawasaki-shi, Kanagawa 211-8588 (JP)
(74) Representative: Haseltine Lake Kempner LLP
(86) International application number: PCT/JP2023/007592
(87) International publication number: WO 2024/180719

(57) **Abstract**

A qubit allocation program of an embodiment causes a computer to execute a process of converting, a process of creating a second graph, a process of specifying, and a process of creating circuit information. The process of converting converts a quantum circuit serving as an operation target into a first graph indicating a connection relation of each gate included in the quantum circuit. The process of creating a second graph creates a second graph from which a gate other than a two-quantum gate included in the first graph is removed, based on the first graph. The process of specifying specifies a graph isomorphic to the second graph from a third graph created based on each of a plurality of the quantum circuits. The process of creating circuit information creates circuit information corresponding to the quantum circuit serving as the operation target, to which a qubit is allocated based on the quantum circuits corresponding to the specified third graph.

## Description

### Technical Field

Embodiments of the present invention relate to a qubit allocation program, a qubit allocation method, and a qubit allocation device.

### Background Art

In recent years, the emergence of a quantum computer referred to as a noisy intermediate-scale quantum computer (NISQ) has made it possible to operate a quantum circuit. In the quantum computer, the types of gates (native gates) that can be used in an actual device are limited. Hence, an operation is performed after converting the quantum circuit into native gates, and allocating qubits to satisfy the constraints of the actual device.

To allocate qubits in such a quantum computer, a configuration that further reduces the number of gates such as a swap gate is desired to improve the overall fidelty of the circuit. As a qubit allocation technique for improving the fidelty, a plurality of templates in which the optimal allocation is calculated in advance, are prepared for frequent patterns of the quantum circuit. Then, there is a conventional technique that, when the actual quantum circuit matches the pattern of a predetermined template, uses the calculation results of the template.

### Citation List

### Patent Literature

Patent Literature 1: Japanese National Publication of International Patent Application No. 2022-510394
Patent Literature 2: U.S. Patent Application Publication No. 2021/0350056
Patent Literature 3: U.S. Patent Application Publication No. 2020/0272926
Non Patent Literature 1: D. M. Miller, D. Maslov, and G. W. Dueck. 2003. A transformation based algorithm for reversible logic synthesis. In Proceedings of the 2003 Design Automation Conference, Anaheim, CA, USA. 318-323. URL: https://doi.org/10.1145/775832.775915
Non Patent Literature 2: D. Maslov, G. W. Dueck, and D. M. Miller. 2003. Simplification of Toffoli networks via templates. In 16th Symposium on Integrated Circuits and Systems Design, Sao Paulo, Brazil. 53-58. URL: https://doi.org/10.1109/SBCCI.2003.1232806
Non Patent Literature 3: A Quantum Circuit Optimization FrameworkBased on Pattern Matching Mingyu Chen, Yu Zhang and Yongshang Li URL: https://doi.org/10.1142/52010324721400087
Non Patent Literature 4: Raban Iten, Romain Moyard, Tony Metger, David Sutter, and Stefan Woerner. 2022. Exact and Practical Pattern Matching for Quantum Circuit Optimization. ACM Transactions on Quantum Computing 3, 1, Article 4 (March 2022), 41 pages. URL: https://doi.org/10.1145/3498325

### Summary of invention

### Technical Problem

However, in the conventional technique described above, a template that completely matches with all gates is searched during a pattern match. Hence, there is a problem in that a long calculation time is needed to match with a large number of templates.

In one aspect, an object is to provide a qubit allocation program, a qubit allocation method, and a qubit allocation device that can easily perform qubit allocation.

### Solution to Problem

According to still another aspect of an embodiment, a qubit allocation program causes a computer to execute a process including converting a quantum circuit serving as an operation target into a first graph indicating a connection relation of each gate included in the quantum circuit, creating a second graph from which a gate other than a two-quantum gate included in the first graph is removed, based on the first graph, specifying a graph isomorphic to the second graph from a third graph created based on each of a plurality of the quantum circuits, and creating circuit information corresponding to the quantum circuit serving as the operation target, to which a qubit is allocated based on the quantum circuits corresponding to the specified third graph.

### Advantageous Effects of Invention

It is possible to easily perform qubit allocation.

### Brief Description of Drawings

FIG. 1 is a block diagram illustrating an example of a hardware configuration of a qubit allocation device according to an embodiment.
FIG. 2 is a block diagram illustrating an example of a functional configuration of the qubit allocation device according to the embodiment.
FIG. 3 is a flowchart illustrating an example of an operation of the qubit allocation device according to the embodiment.
FIG. 4 is an explanatory diagram for explaining an example of target quantum circuit information.
FIG. 5 is an explanatory diagram for explaining an example of divided circuits and constraints of the actual device.
FIG. 6 is an explanatory diagram for explaining an example of decomposition into native gates.
FIG. 7 is an explanatory diagram for explaining the conversion of a circuit into a canonical form (graph).
FIG. 8 is an explanatory diagram for explaining the deletion of an unmatched gate included in the canonical form (graph).
FIG. 9 is an explanatory diagram for explaining an example of a template.
FIG. 10 is an explanatory diagram for explaining a graph of the template.
FIG. 11 is an explanatory diagram for explaining graph isomorphism determination.
FIG. 12 is an explanatory diagram for explaining the creation of allocated circuit information.
FIG. 13 is an explanatory diagram for explaining the synthesis of circuit information.

### Description of Embodiments

Hereinafter, a qubit allocation program, a qubit allocation method, and a qubit allocation device according to an embodiment will be described with reference to the drawings. In the embodiment, components having the same function are denoted by the same reference numerals, and repeated descriptions are omitted. The qubit allocation program, the qubit allocation method, and the qubit allocation device described in the following embodiments are merely examples, and are not intended to limit the embodiments. Moreover, the following embodiments may be appropriately combined within a range that does not contradict each other.

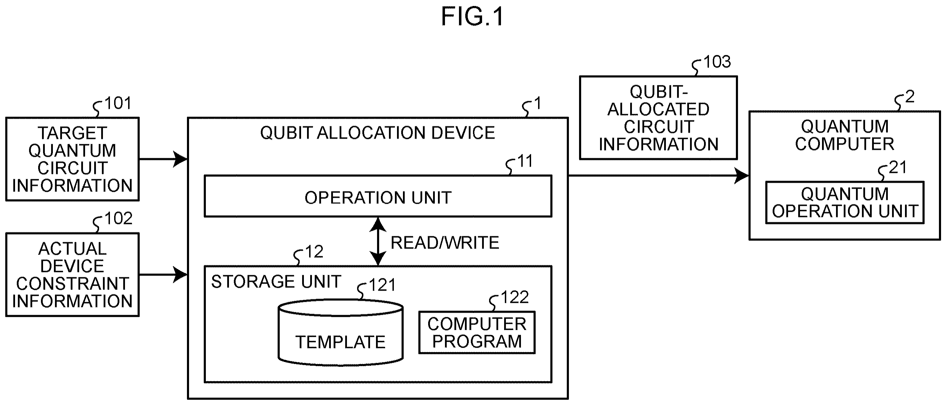

FIG. 1 is a block diagram illustrating an example of a hardware configuration of a qubit allocation device according to an embodiment. As illustrated in FIG. 1, a qubit allocation device 1 receives target quantum circuit information 101 on a quantum circuit serving as an operation target (target) and actual device constraint information 102 on a gate (native gate) that can be used in a quantum operation unit 21 of a quantum computer 2, and creates qubit-allocated circuit information 103 indicating a circuit to which qubits are allocated to satisfy the constraints of the actual device.

Specifically, the qubit allocation device 1 prepares a plurality of templates 121 where the optimal allocation is calculated in advance, for each of the frequent patterns of the quantum circuit. Then, when the quantum circuit serving as an operation target matches the pattern of a predetermined template 121, the qubit allocation device 1 creates the qubit-allocated circuit information 103, to which qubits are allocated on the basis of the matched template 121 (details will be described below).

On the basis of the qubit-allocated circuit information 103 generated by the qubit allocation device 1, the quantum computer 2 allocates qubits in the quantum operation unit 21. Consequently, the quantum operation unit 21 of the quantum computer 2 operates the quantum circuit serving as an operation target.

The qubit allocation device 1 includes an operation unit 11 and a storage unit 12, and for example, a personal computer (PC) or the like can be applied. In addition to the operation unit 11 and the storage unit 12, the qubit allocation device 1 may include a communication interface for communicating with the outside, an input device such as a keyboard and a mouse, and an output device such as a display.

For example, the operation unit 11 is implemented by a central processing unit (CPU), a graphics processing unit (GPU), hardwired logic such as an application specific integrated circuit (ASIC) or a field programmable gate array (FPGA), and the like.

The storage unit 12 corresponds to a semiconductor memory element such as a random access memory (RAM) and a flash memory (flash memory), or a storage device such as a hard disk drive (HDD). For example, the storage unit 12 stores the template 121 and a computer program 122.

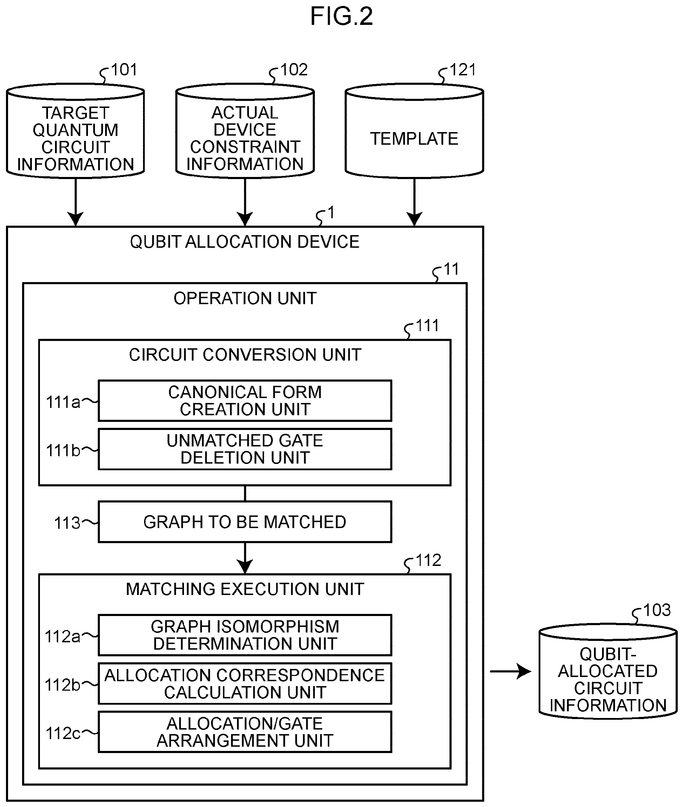

The template 121 is obtained by calculating in advance the optimal qubit allocation, for each of the frequent patterns of the quantum circuit (a plurality of quantum circuits) serving as an operation target in the quantum computer 2. The computer program 122 is a program code for executing various processes in the functional configuration of the operation unit 11 (see FIG. 2).

By reading the computer program 122 stored in the storage unit 12 and sequentially executing the read computer program 122, the operation unit 11 performs processes such as qubit allocation.

FIG. 2 is a block diagram illustrating an example of a functional configuration of the qubit allocation device 1 according to the embodiment. As illustrated in FIG. 2, by executing the computer program 122, the operation unit 11 provides functions as a circuit conversion unit 111 and a matching execution unit 112.

On the basis of the target quantum circuit information 101, the circuit conversion unit 111 is a processing unit that converts a quantum circuit serving as an operation target into a graph indicating the connection relation of the gates included in the quantum circuit, and that creates a graph to be matched 113 that is to be matched with the template 121. Specifically, the circuit conversion unit 111 includes a canonical form creation unit 111a and an unmatched gate deletion unit 111b.

The canonical form creation unit 111a is a processing unit that converts the quantum circuit serving as an operation target into a canonical form, on the basis of the target quantum circuit information 101. A known technique described in "Md. Mazder Rahman, GerhardW. Dueck, and Joseph D. Horton. 2014. An algorithm for quantum template matching. J. Emerg. Technol. Comput. Syst. 11, 3, Article 31 (Dec. 2014), 20 pages. https://doi.org/10.1145/2629537" is used to convert the quantum circuit into a canonical form.

For example, in converting the quantum circuit into a canonical form, the canonical form creation unit 111a treats the circuits obtained by rearranging the commutative gates as the same circuit. Moreover, when the quantum circuit is converted into a canonical form, commutative gates are connected in parallel and non-commutative gates are connected in series. In this manner, the canonical form creation unit 111a converts the quantum circuit serving as an operation target, into a canonical form (graph) indicating the connection relation of the gates included in the quantum circuit.

The unmatched gate deletion unit 111b is a processing unit that creates the graph to be matched 113 from which a gate other than a two-quantum gate is removed from the gates in the graph, on the basis of the canonical form (graph) converted by the canonical form creation unit 111a.

The two-quantum gate in the canonical form (graph) is a gate related to the graph shape (topology), and is a gate directly related to the allocation of qubits. In contrast, a one-quantum gate or the like other than the two-quantum gate is a gate that is not directly related to the allocation of qubits.

The unmatched gate deletion unit 111b creates the graph to be matched 113 by deleting a gate that is not directly related to the allocation of qubits as the unmatched gate, by removing the gate other than the two-quantum gate, in the canonical form (graph) converted by the canonical form creation unit 111a.

The matching execution unit 112 is a processing unit that matches the graph to be matched 113 with a graph based on the circuit included in each of the prepared templates 121 (isomorphic graph search). The matching execution unit 112 creates the qubit-allocated circuit information 103, to which qubits are allocated on the basis of the template 121 matched by this matching, and the actual device constraint information 102. Specifically, the matching execution unit 112 includes a graph isomorphism determination unit 112a, an allocation correspondence calculation unit 112b, and an allocation/gate arrangement unit 112c.

The graph isomorphism determination unit 112a compares between the graph to be matched 113 and the graphs of the prepared templates 121 (details will be described below), and searches (specifies) the isomorphic graphs in which the nodes (gate types) in the graphs match with each other.

The allocation correspondence calculation unit 112b calculates the corresponding relation between the nodes (gates) in the graph searched by the graph isomorphism determination unit 112a and the graph of the graph to be matched 113 (correspondence between the allocations of qubits). Specifically, the allocation correspondence calculation unit 112b collects the constraints (corresponding relation) of the qubits in each of the two-quantum gates in the graph. As an example, if the two-quantum gate is CNOT_{a→b} in which a qubit a is a control bit and a qubit b is a target bit, a→b is the constraints (corresponding relation) of the qubits.

The allocation correspondence calculation unit 112b collects the constraints of each node in the graph searched by the graph isomorphism determination unit 112a and the graph to be matched 113, and determines whether the constraints of the nodes correspond without contradiction. If there is no contradiction in the constraints (corresponding relation), the allocation correspondence calculation unit 112b assumes that the graph searched by the graph isomorphism determination unit 112a matches with the graph of the graph to be matched 113 (successful pattern match). On the contrary, if there is a contradiction in the constraints (corresponding relation), the allocation correspondence calculation unit 112b assumes that the pattern match has failed.

The allocation/gate arrangement unit 112c is a processing unit that allocates qubits, that arranges gates, and that creates the qubit-allocated circuit information 103, on the basis of the template 121 corresponding to the graph with a successful pattern match.

Specifically, the allocation/gate arrangement unit 112c allocates qubits so that the quantum circuit of the template 121 corresponding to the graph with a successful pattern match satisfies the constraints of the actual device of the quantum computer 2 indicated by the actual device constraint information 102. Moreover, the allocation/gate arrangement unit 112c arranges the two-quantum gate/swap gate according to the template 121. In this example, the allocation/gate arrangement unit 112c arranges the one-quantum gate or the like in a desired manner within a range where the calculation results of the circuit do not change. In this manner, the allocation/gate arrangement unit 112c creates the qubit-allocated circuit information 103, and outputs the created qubit-allocated circuit information 103 to the quantum computer 2.

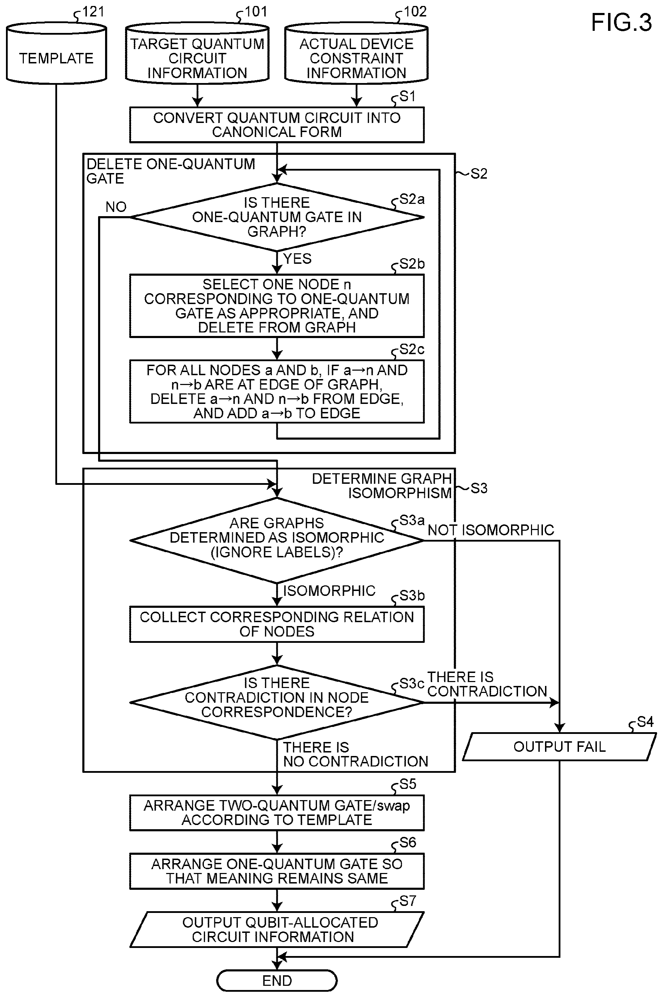

FIG. 3 is a flowchart illustrating an example of an operation of the qubit allocation device 1 according to the embodiment. As illustrated in FIG. 3, when the process is started after receiving the target quantum circuit information 101 and the actual device constraint information 102, the canonical form creation unit 111a converts the quantum circuit serving as an operation target into a canonical form (S1).

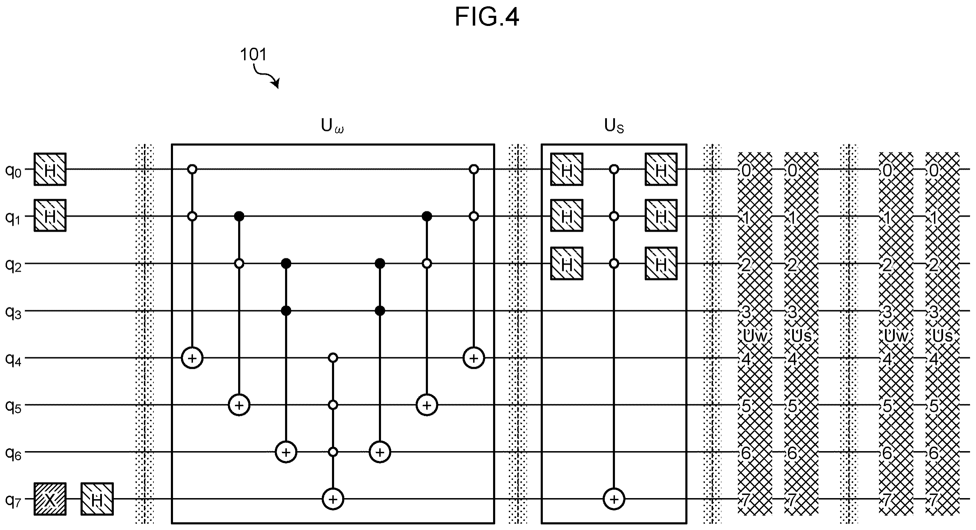

FIG. 4 is an explanatory diagram for explaining an example of the target quantum circuit information 101. As the target quantum circuit information 101, FIG. 4 illustrates an example related to the quantum circuit for solving the satisfiability problem (2-SAT problem) of (x₀ ∨ x₁) ∧ (¬x₁ V X2) A (¬x₂ ∨ ¬x₃).

The operation unit 11 of the qubit allocation device 1 divides the quantum circuit included in the target quantum circuit information 101, and creates circuit information to which qubits have already been allocated for each of the divided circuits. For example, in the case of the target quantum circuit information 101 illustrated in FIG. 4, the quantum circuit may be divided by circuit parts such as Uω and Us. The division of the quantum circuit is to be performed by a user as appropriate. Then, the operation unit 11 of the qubit allocation device 1 creates the qubit-allocated circuit information 103 corresponding to the quantum circuit serving as an operation target, by synthesizing a plurality of pieces of circuit information created for each of the divided circuits, by inserting a swap gate to match the allocation of the qubits.

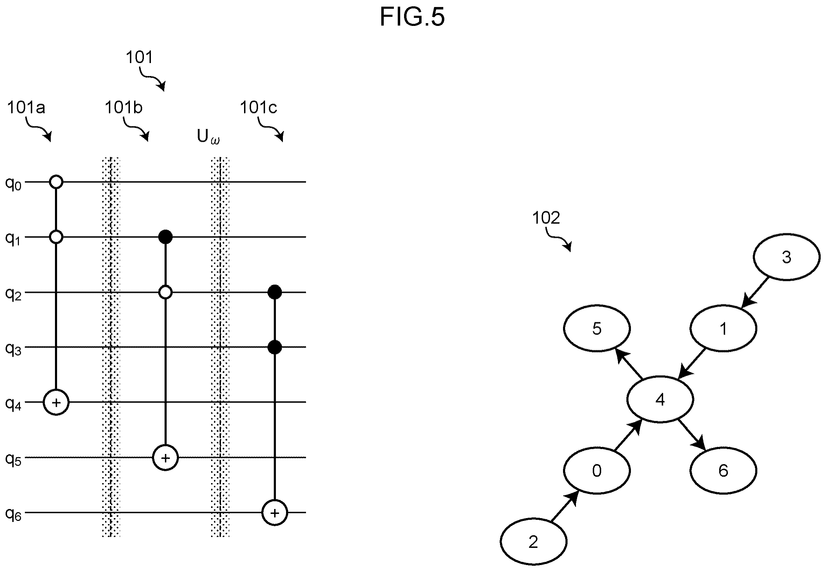

FIG. 5 is an explanatory diagram for explaining an example of divided circuits and constraints of the actual device. As illustrated in FIG. 5, for the target quantum circuit information 101, processing is performed by dividing a part of the circuit part of Uω into circuits 101a, 101b, and 101c.

Moreover, the actual device constraint information 102 includes the direction of CNOT in the qubit (Q: may also be referred to as a physical qubit) on the quantum computer 2 side. In the illustrated actual device constraint information 102, for Q0 and Q2, Q2→Q0 and Q0→Q4 are illustrated as the constraints of the actual device (CNOT direction). For Q1 and Q3, Q1→Q4 and Q3→Q1 are illustrated as the constraints of the actual device. For Q4, Q5, and Q6, Q4→Q5 and Q4→Q6 are illustrated as the constraints of the actual device.

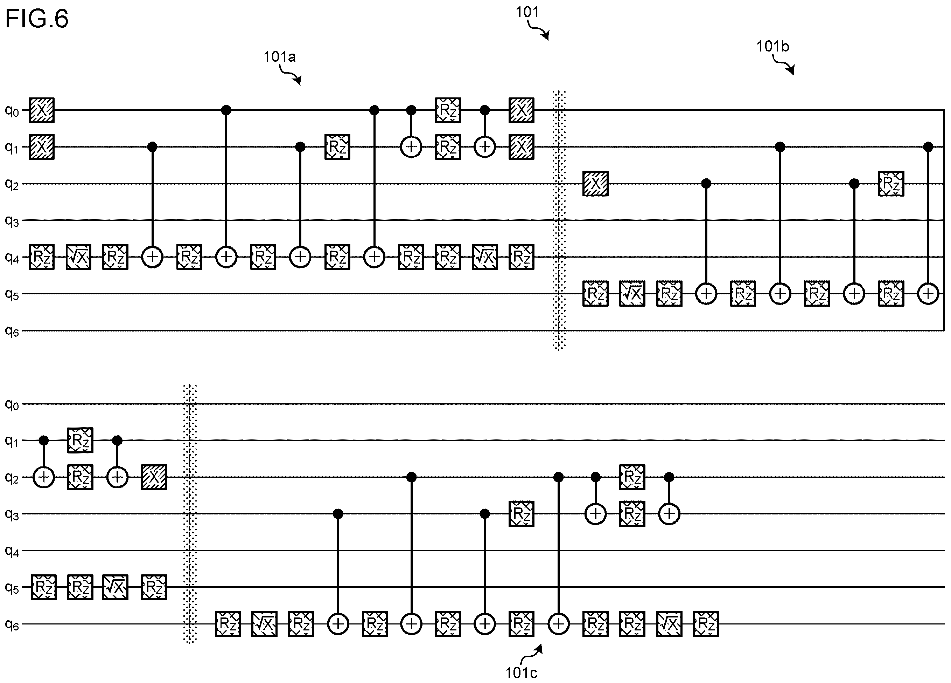

FIG. 6 is an explanatory diagram for explaining an example of decomposition into native gates. The circuits 101a, 101b, and 101c illustrated in FIG. 5 can be decomposed into native gates as illustrated in FIG. 6, by ignoring the connection of physical qubits. As an example, it is assumed that the native gates are X, √X, CONT, and Rz. For the gates other than CONT in the native gates, the descriptions of π/4, π/2, -π/4, and the like are simplified.

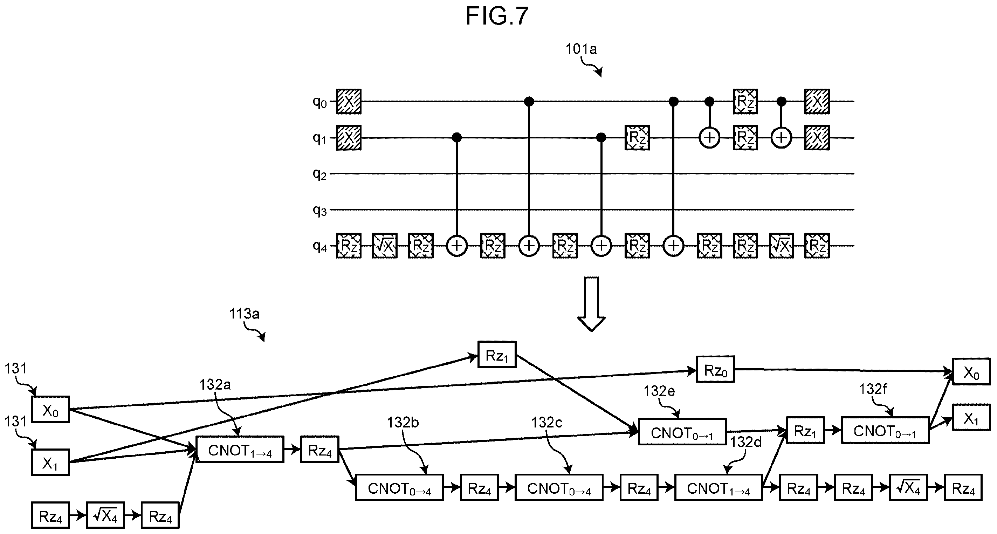

FIG. 7 is an explanatory diagram for explaining the conversion of the circuit 101a into a canonical form (graph). As illustrated in FIG. 7, the canonical form creation unit 111a converts the circuit 101a into a canonical form (graph) 113a indicating the connection relation of one-quantum gates 131 (X, √X, Rz) and two-quantum gates 132a to 132f (CNOT). The labels (numbers) in the drawing indicate the qubits (q: may also be referred to as logical qubits) of the target quantum circuit information 101. Moreover, if there is no need to particularly distinguish the two-quantum gates 132a to 132f, the two-quantum gates 132a to 132f may be referred to as a two-quantum gate 132.

Returning to FIG. 3, after S1, the unmatched gate deletion unit 111b performs a process of deleting the unmatched gate (one-quantum gate 131) other than the two-quantum gate 132 from the gates in the canonical form (graph) 113a (S2).

Specifically, the unmatched gate deletion unit 111b determines whether there is the one-quantum gate 131 in the canonical form (graph) 113a (S2a), and if there is no one-quantum gate 131 (No at S2a), proceeds the process to S3.

If there is the one-quantum gate 131 (Yes at S2a), the unmatched gate deletion unit 111b selects one node (n) corresponding to the one-quantum gate 131 as appropriate (at random), and deletes the selected node (n) from the canonical form (graph) 113a (S2b). Then, for all nodes a and b, if there are a→n and n→b at the edge of the canonical form (graph) 113a, the unmatched gate deletion unit 111b deletes a→n and n→b from the edge. Moreover, the unmatched gate deletion unit 111b adds a→b to the edge (S2c). In this manner, the unmatched gate deletion unit 111b connects the deleted node parts to the canonical form (graph) 113a, and returns the process to S2a.

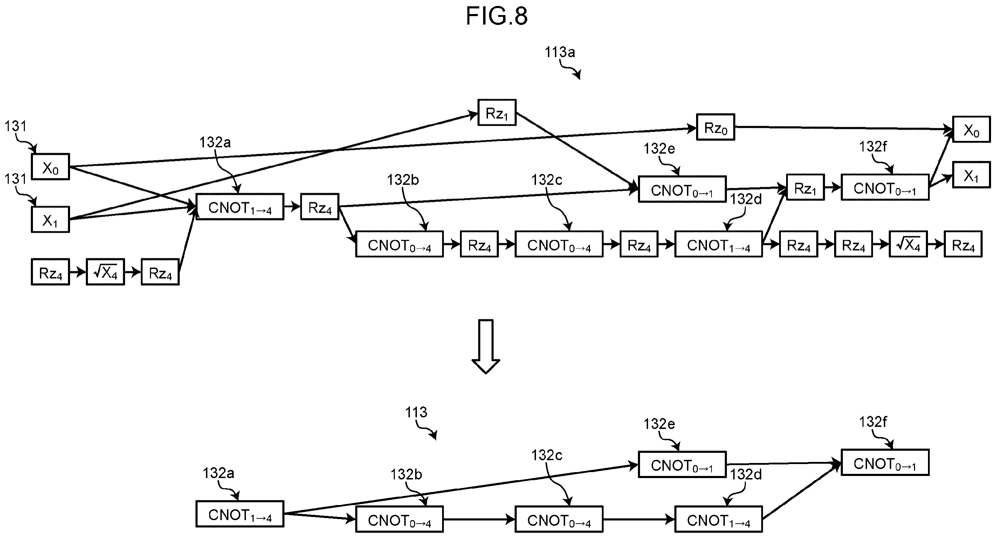

FIG. 8 is an explanatory diagram for explaining the deletion of an unmatched gate included in the canonical form (graph). As illustrated in FIG. 8, the unmatched gate deletion unit 111b creates the graph to be matched 113, by deleting the one-quantum gate 131 other than the two-quantum gates 132a to 132f related to the graph shape (topology) included in the canonical form (graph) 113a.

Returning to FIG. 3, after S2, the matching execution unit 112 compares between the graph to be matched 113 created by the circuit conversion unit 111 and the graph based on the circuit included in each of the prepared templates 121, and performs graph isomorphism determination (S3).

Specifically, the graph isomorphism determination unit 112a compares between the shapes of the created graph to be matched 113 and the graph based on the circuit included in each of the prepared templates 121, while ignoring the labels (numbers) related to the qubits, and determines whether the graphs are isomorphic (S3a).

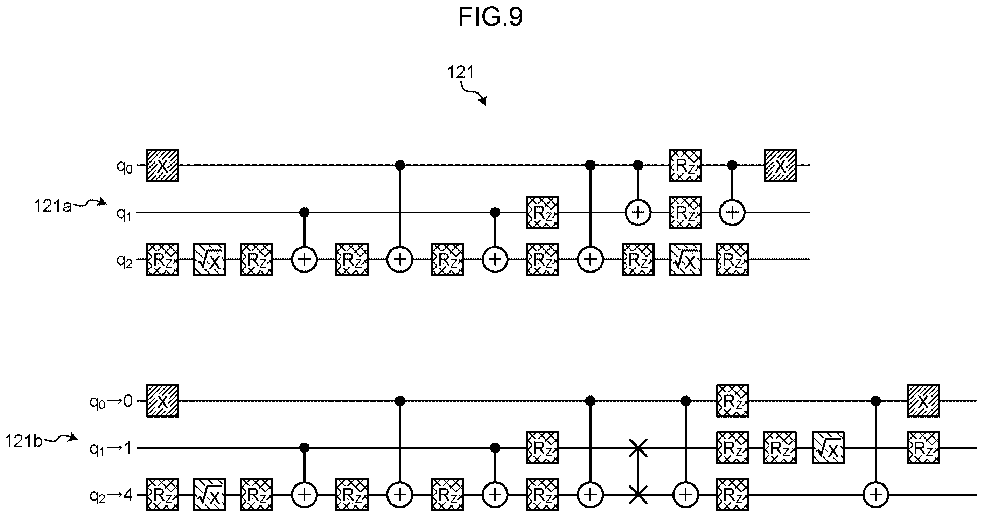

FIG. 9 is an explanatory diagram for explaining an example of the template 121. As illustrated in FIG. 9, the template 121 includes a set of a circuit pattern 121a and allocated circuit information 121b. The circuit pattern 121a is an example of a short circuit that has already been decomposed into the native gates of the qubit allocation device 1. The allocated circuit information 121b is circuit information in which the optimal allocation (qubits have already been allocated, and a swap gate has already been inserted) has been made to the circuit pattern 121a to improve the overall fidelty.

The matching execution unit 112 compares between the graph based on the circuit pattern 121a included in the template 121 and the graph to be matched 113 created by the circuit conversion unit 111. The graph based on the circuit pattern 121a may be created in advance when the template 121 is created, or may be created by the circuit conversion unit 111 at the time of comparison.

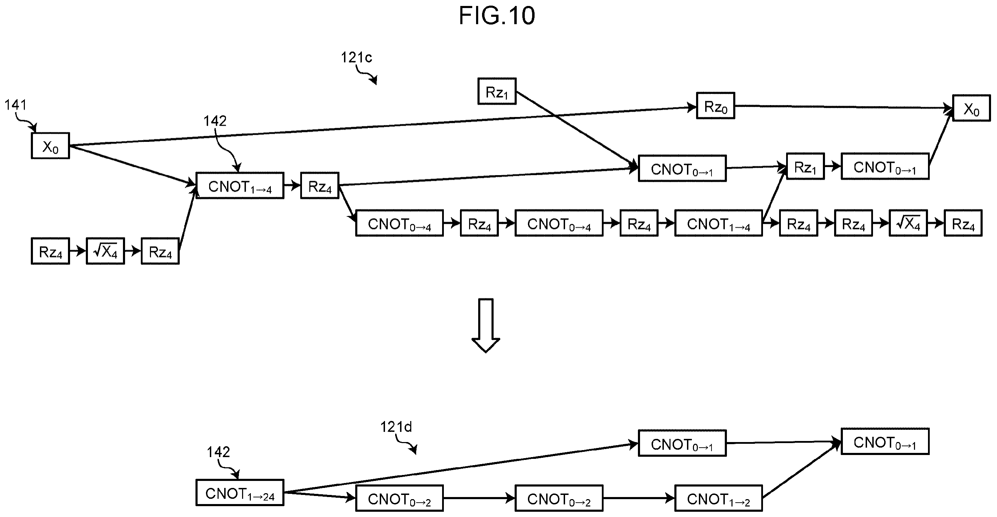

FIG. 10 is an explanatory diagram for explaining a graph of the template 121. As illustrated in FIG. 10, for the template 121, a canonical form (graph) 121c is created by converting the circuit pattern 121a into a canonical form. In this example, the canonical form (graph) 121c may also be a graph 121d from which a one-quantum gate 141 other than a two-quantum gate 142 is removed from the gates in the graph.

In comparing the graph shape with the graph to be matched 113, the graph based on the circuit pattern 121a can be either the canonical form (graph) 121c or the graph 121d. However, to reduce the amount of calculation during comparison, it is preferable to use the graph 121d in which the number of nodes will be less. In the present embodiment, the graph 121d based on the circuit pattern 121a is to be compared with the graph to be matched 113.

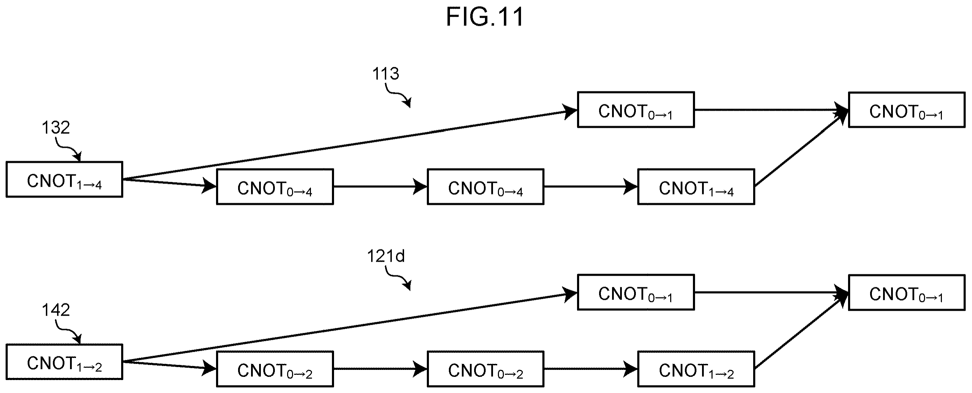

FIG. 11 is an explanatory diagram for explaining graph isomorphism determination. As illustrated in FIG. 11, the graph isomorphism determination unit 112a compares between the graph to be matched 113 and the graph 121d, and determines whether the graphs are isomorphic using an existing graph isomorphism determination method. At this point, the graph isomorphism determination unit 112a ignores the labels (a, b) of CNOT_{a→b} in the two-quantum gate 132 of the graph to be matched 113 and the two-quantum gate 142 of the graph 121d, and only determines whether the shapes of the graphs are isomorphic.

Returning to FIG. 3, if the shapes of the graphs are not isomorphic at S3a, the matching execution unit 112 outputs fail (S4) because no graph matches the template 121, and terminates the process. If the shapes of the graphs are isomorphic at S3a, the allocation correspondence calculation unit 112b collects the corresponding relation between the nodes (gates) in the graph 121d determined as isomorphic and the graph to be matched 113 (S3b), and determines whether there is a contradiction in the collected node correspondence (S3c).

For example, in the example of FIG. 11, the correspondence (qubit allocation correspondence) of the node (two-quantum gate 142) of the graph 121d with respect to the node (two-quantum gate 132) of the graph to be matched 113 is {0→0, 1→1, 4→2}. Hence, there is no contradiction in the corresponding relation. Therefore, the allocation correspondence calculation unit 112b determines that there is no contradiction.

If there is a contradiction at S3c, the matching execution unit 112 outputs fail (S4) because no graph matches the template 121, and terminates the process. If there is no contradiction at S3c, the allocation/gate arrangement unit 112c allocates the qubits according to the corresponding relation without contradiction, and arranges the two-quantum gate/swap gate according to the allocated circuit information 121b of the template 121 (S5). Then, the allocation/gate arrangement unit 112c arranges the one-quantum gate so that the meaning (calculation results of the circuit) remains the same (S6). Then, the allocation/gate arrangement unit 112c outputs the qubit-allocated circuit information 103 (S7) created in the processes at S5 and S6, and terminates the process.

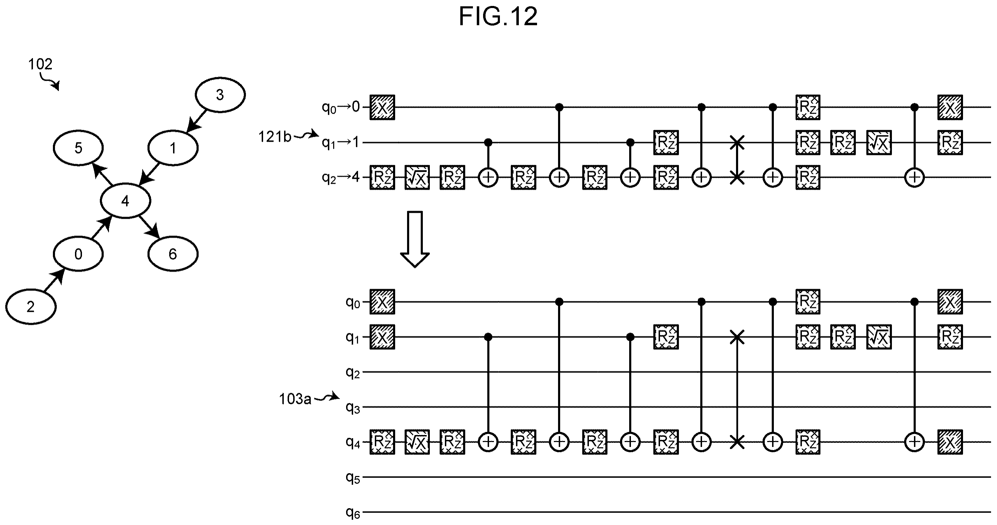

FIG. 12 is an explanatory diagram for explaining the creation of allocated circuit information. As illustrated in FIG. 12, the allocation/gate arrangement unit 112c allocates the qubits (q0, q1, q2) according to the corresponding relation {0→0, 1→1, 4→2} without contradiction. Moreover, the matching execution unit 112 creates circuit information 103a corresponding to the circuit 101a, by arranging the two-quantum gate/swap gate according to the allocated circuit information 121b of the template 121, and arranging the one-quantum gate so that the meaning remains the same.

Similar to the circuit 101a, for the circuits 101b and 101c also, the matching execution unit 112 creates circuit information 103b and 103c corresponding to the circuits 101b and 101c, respectively. Then, the matching execution unit 112 creates the qubit-allocated circuit information 103 corresponding to the quantum circuit serving as an operation target, by synthesizing the circuits 101a, 101b, 101c ..., by inserting a swap gate to match the allocation of the qubits.

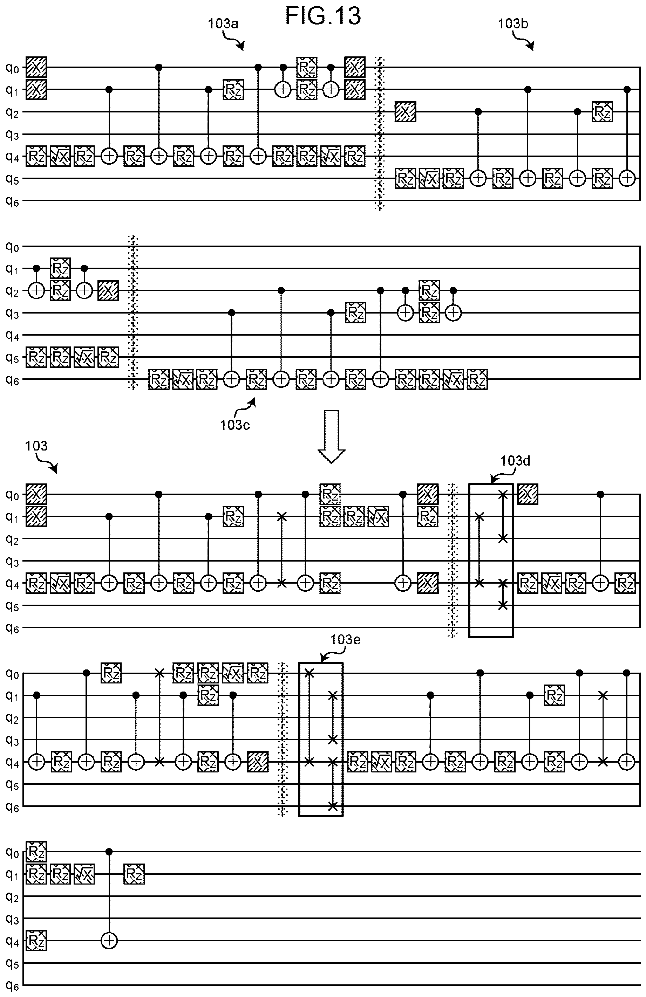

FIG. 13 is an explanatory diagram for explaining the synthesis of the circuit information 103a, 103b, and 103c. As illustrated in FIG. 13, the matching execution unit 112 creates the qubit-allocated circuit information 103, by synthesizing the pieces of circuit information 103a, 103b, and 103c, by inserting swap gates 103d and 103e to match the allocation of the qubits (q0 to q6).

As described above, the qubit allocation device 1 converts the quantum circuit serving as an operation target, into a first graph (canonical form (graph) 113a) indicating the connection relation of the gates in the quantum circuit. On the basis of the first graph, the qubit allocation device 1 creates a second graph (graph to be matched 113) from which the gate other than the two-quantum gate 132 included in the first graph is removed. The qubit allocation device 1 specifies the graph isomorphic to the second graph from a third graph (graph 121d) created on the basis of each of the quantum circuits of the template 121. The qubit allocation device 1 creates the qubit-allocated circuit information 103 corresponding to the quantum circuit serving as an operation target, to which qubits are allocated on the basis of the quantum circuit of the template 121 corresponding to the specified third graph.

Consequently, because the gate included in the graph to be matched is reduced, the qubit allocation device 1 can reduce the calculation time during which the graph is matched with the template, and easily perform qubit allocation.

Moreover, in the qubit allocation device 1, the third graph (graph 121d) is a graph from which the gate other than the two-quantum gate 142 in the graph is removed, in the graph (canonical form (graph) 121c) indicating the connection relation of the gates included in the quantum circuit of the template 121. In this manner, by removing the gate other than the two-quantum gate 142 in the third graph (graph 121d) also, the qubit allocation device 1 can reduce the calculation time during which the graph is matched with the template, and easily perform qubit allocation.

Moreover, the qubit allocation device 1 creates the qubit-allocated circuit information 103 corresponding to the quantum circuit serving as an operation target, by synthesizing a plurality of pieces of the circuit information 103a, 103b, and 103c created for each of the divided circuits obtained by dividing the quantum circuit serving as an operation target, by inserting the swap gates 103d and 103e to match the allocation of the qubits. Consequently, in the qubit allocation device 1, there is no need to prepare a huge number of templates by assuming the entire quantum circuit serving as an operation target. For example, in the qubit allocation device 1, as a template assuming the divided circuits obtained by dividing the quantum circuit serving as an operation target, a versatile template that can be commonly used by a large number of quantum circuits may be prepared. Therefore, with the qubit allocation device 1, many circuits match with a single template, and it is expected that the number of templates can be reduced.

The components of the devices illustrated in the drawings need not be physically configured as illustrated in the drawings. In other words, the specific mode of dispersion and integration of each device is not limited to the ones illustrated in the drawings, and all or a part thereof can be functionally or physically dispersed or integrated in any unit, depending on various loads, usage condition, and the like.

For example, all or any part of various processing functions of the circuit conversion unit 111 and the matching execution unit 112 performed in the operation unit 11 of the qubit allocation device 1 may be executed on a CPU (or a microcomputer such as an MPU or a micro controller unit (MCU)). Moreover, it is needless to say that all or any part of various processing functions may be executed on a computer program analyzed and executed by a CPU (or a microcomputer such as an MPU or an MCU) or on hardware by wired logic. Furthermore, various processing functions performed by the qubit allocation device 1 may be executed by cloud computing in cooperation with a plurality of computers.

Still furthermore, the computer program 122 does not have to be stored in the storage unit 12. For example, the qubit allocation device 1 may read and execute the computer program 122 stored in a readable storage medium. For example, a portable recording medium such as a CD-ROM, a DVD disk, and a universal serial bus (USB) memory; a semiconductor memory such as a flash memory; a hard disk drive; and the like correspond to the storage medium that can be read by the qubit allocation device 1. Still furthermore, the computer program 122 may be stored in devices connected to a public line, the Internet, a LAN, and the like, and the qubit allocation device 1 may read and execute the computer program 122 from these devices.

Still furthermore, in the present embodiment, the two-quantum gate included in the quantum circuit is CNOT. However, the two-quantum gate is not limited to CNOT. For example, the two-quantum gate included in the quantum circuit may also be a gate other than CNOT such as CX, CY, CZ, CRx, CRy, and CRz.

### Reference Signs List

1 qubit allocation device
2 quantum computer
N network
11 operation unit
12 storage unit
21 quantum operation unit
101 target quantum circuit information
101a to 101c circuit
102 actual device constraint information
103 qubit-allocated circuit information
103a to 103c circuit information
103d, 103e swap gate
111 circuit conversion unit
111a canonical form creation unit
111b unmatched gate deletion unit
112 matching execution unit
112a graph isomorphism determination unit
112b allocation correspondence calculation unit
112c allocation/gate arrangement unit
113 graph to be matched
113a, 121c canonical form (graph)
121 template
121a circuit pattern
121b allocated circuit information
121d graph
122 computer program
131, 141 one-quantum gate
132, 132a to 132f, 142 two-quantum gate

## Claims

1. A qubit allocation program that causes a computer to execute a process comprising:
converting a quantum circuit serving as an operation target into a first graph indicating a connection relation of each gate included in the quantum circuit;
creating a second graph from which a gate other than a two-quantum gate included in the first graph is removed, based on the first graph;
specifying a graph isomorphic to the second graph from a third graph created based on each of a plurality of the quantum circuits; and
creating circuit information corresponding to the quantum circuit serving as the operation target, to which a qubit is allocated based on the quantum circuits corresponding to the specified third graph.

2. The qubit allocation program according to claim 1, wherein in a graph indicating a connection relation of each gate included in the quantum circuits, the third graph is a graph from which a gate other than a two-quantum gate included in the graph is removed.

3. The qubit allocation program according to claim 1, wherein the process of creating the circuit information creates circuit information corresponding to the quantum circuit serving as the operation target, by synthesizing a plurality of pieces of circuit information created for each of divided circuits obtained by dividing the quantum circuit serving as the operation target, by inserting a swap gate to match the allocation of the qubit.

4. The qubit allocation program according to claim 1, wherein the two-quantum gate is a CNOT gate.

5. A qubit allocation method causing a computer to execute a process, comprising:
converting a quantum circuit serving as an operation target into a first graph indicating a connection relation of each gate included in the quantum circuit;
creating a second graph from which a gate other than a two-quantum gate included in the first graph is removed, based on the first graph;
specifying a graph isomorphic to the second graph from a third graph created based on each of a plurality of the quantum circuits; and
creating circuit information corresponding to the quantum circuit serving as the operation target, to which a qubit is allocated based on the quantum circuits corresponding to the specified third graph.

6. The qubit allocation method according to claim 5, wherein in a graph indicating a connection relation of each gate included in the quantum circuits, the third graph is a graph from which a gate other than a two-quantum gate included in the graph is removed.

7. The qubit allocation method according to claim 5, wherein the process of creating the circuit information creates circuit information corresponding to the quantum circuit serving as the operation target, by synthesizing a plurality of pieces of circuit information created for each of divided circuits obtained by dividing the quantum circuit serving as the operation target, by inserting a swap gate to match the allocation of the qubit.

8. The qubit allocation method according to claim 5, wherein the two-quantum gate is a CNOT gate.

9. A qubit allocation device comprising:
an operation unit configured to execute a process of
converting a quantum circuit serving as an operation target into a first graph indicating a connection relation of each gate included in the quantum circuit;
creating a second graph from which a gate other than a two-quantum gate included in the first graph is removed, based on the first graph;
specifying a graph isomorphic to the second graph from a third graph created based on each of a plurality of the quantum circuits; and
creating circuit information corresponding to the quantum circuit serving as the operation target, to which a qubit is allocated based on the quantum circuits corresponding to the specified third graph.

10. The qubit allocation device according to claim 9, wherein in a graph indicating a connection relation of each gate included in the quantum circuits, the third graph is a graph from which a gate other than a two-quantum gate included in the graph is removed.

11. The qubit allocation device according to claim 9, wherein the process of creating the circuit information creates circuit information corresponding to the quantum circuit serving as the operation target, by synthesizing a plurality of pieces of circuit information created for each of divided circuits obtained by dividing the quantum circuit serving as the operation target, by inserting a swap gate to match the allocation of the qubit.

12. The qubit allocation device according to claim 9, wherein the two-quantum gate is a CNOT gate.
